# EUROPEAN PATENT APPLICATION

(11) **EP 1 422 320 A1**
(43) Date of publication of application: **26.05.2004**
(21) Application number: 03257256.2
(22) Date of filing: 18.11.2003
(51) Int. Cl.: C25D 3/38

(54) **Copper electroplating bath**

(30) Priority: 21.11.2002 US 428161 P; 20.12.2002 US 435920 P
(71) Applicant: Shipley Company, L.L.C., Boston, MA 01752 (US)
(72) Inventor: Mikkola, Robert D., Grafton Massachusetts 01536 (US); Wang, Deyan, Hudson Massachusetts 01749 (US); Wu, Chunyi, Westford Massachusetts 01886 (US)
(74) Representative: Kent, Venetia Katherine

(57) **Abstract**

Copper electroplating baths are provided containing as one or more suppressor compounds poly(alkylene oxide) random copolymers which are capable of providing copper filled sub-micron sized apertures free of pits and voids. Such copper electroplating baths are useful in the manufacture of electronic devices, such as printed wiring boards and integrated circuits.

## Description

### Background of the Invention

The present invention relates generally to the field of electroplating. In particular, the present invention relates to the field of electroplating copper on a substrate.

Methods for electroplating articles with metal coatings generally involve passing a current between two electrodes in a plating solution where one of the electrodes is the article to be plated. A typical acid copper plating solution comprises dissolved copper (usually copper sulfate), an acid electrolyte such as sulfuric acid in an amount sufficient to impart conductivity to the bath, and proprietary additives to improve the uniformity of the plating and the quality of the metal deposit. Such additives include brighteners, levelers, surfactants, suppressors, and the like.

Electrolytic copper plating solutions are used for many industrial applications. For example, they are used in the automotive industry to deposit base layers for subsequently applied decorative and corrosion protective coatings. They are also used in the electronics industry, particularly for the fabrication of printed circuit boards and integrated circuits. For circuit board fabrication, copper is electroplated over selected portions of the surface of a printed circuit board and onto the walls of through holes passing between the surfaces of the circuit board base material. The walls of a through hole are first metallized to provide conductivity between the board's circuit layers. For semiconductor fabrication, copper is electroplated over the surface of a wafer containing a variety of features such as vias, trenches or a combination thereof. The vias and trenches are metallized to provide conductivity between various layers of the semiconductor device.

It is well known in certain areas of plating, such as in electroplating of electronic devices, that the use of additives in the electroplating bath can be crucial in achieving a uniform and defect-free metal deposit on a substrate surface. For example, conventional electrochemical metallization processes for advanced interconnects use an electroplating bath containing sulfuric acid (10-100 g/L H₂SO₄), cupric ions (30-50 g/L), and chloride ions (50-70 mg/L). An organic additive package is used to assist in the development of bottom-up fill, and to promote a uniform thickness of copper across the wafer. Such additive package typically includes accelerators, suppressors and levelers and may optionally include surfactants, defoamers, or ductilizers for the purpose of modifying the properties of the plating bath or the resultant metal deposits. A balance must be struck between the use of such accelerators, suppressors, levelers, and other additives to achieve the desired level of copper fill of apertures without void formation. If such balance is not achieved, then the plating across the wafer may occur much faster than plating within the aperture, resulting in void formation within the apertures.

Plating a substrate having sub-micron sized apertures, such as those found in integrated circuits, can pose particular difficulties using such electroplating baths. During the filling of such sub-micron sized apertures with copper using an electroplating bath containing suppressors, defects, such as pits or voids often result. For example, when conventional polyethylene glycols are used as suppressors, the resulting copper deposits typically contain defects protruding upward from the surface of the deposit ("protrusions"). Copper deposits obtained from electroplating baths containing ethylene oxide/propylene oxide block copolymers typically contain pits or lines of pits on the surface of the deposit. Such defects can lead to electrical shorts and reliability problems in electronic devices. There is a need for copper electroplating baths containing suppressors that provide copper deposits, particularly copper filled sub-micron sized apertures, free of defects.

### Summary of the Invention

It has been surprisingly found that the elimination of defects in copper deposits and particularly in copper deposits within sub-micron sized apertures can be accomplished by modification of the organic additive package used in the copper electroplating bath. Such organic additive package modification is achieved by the use of certain suppressor compounds.

The present invention provides an electroplating bath including a source of metal ions, an electrolyte and one or more suppressor compounds, wherein the one or more suppressor compounds is capable of providing a copper filled, sub-micron sized aperture free of pits and voids. Also provided by the present invention is a composition including one or more sources of copper ions, an electrolyte and one or more polyalkylene oxide random copolymers comprising as polymerized units two or more alkylene oxide monomers. Preferably, the suppressor compounds are ethylene oxide-propylene oxide random copolymers.

Further provided by the present invention is a method of depositing a metal layer on a substrate including the steps of: a) contacting a substrate with the electroplating bath described above; and b) subjecting the electroplating bath to a current density sufficient to deposit the metal layer. Still further, the present invention provides a method of depositing a layer of copper on a substrate including the steps of contacting the substrate with the composition described above and applying current density for a period of time sufficient to deposit a layer of copper on the substrate.

The present invention additionally provides a method of manufacturing an electronic device including the steps of: a) contacting an electronic device with the electroplating bath described above; and b) subjecting the electroplating bath to a current density sufficient to deposit the metal layer on the electronic device. Also provided by the present invention is a method of manufacturing an electronic device including the step of depositing a layer of copper on an electronic device substrate including the steps of contacting the electronic device substrate with the composition described above and applying current density for a period of time sufficient to deposit a layer of copper on the electronic device substrate.

The invention also includes articles of manufacture, including electronic devices such as printed circuit boards, multichip modules, integrated circuits and the like that contain a copper deposit produced from a plating solution of the invention. In addition, the present invention provides an article of manufacture including an electronic device containing one or more apertures, each aperture containing an electrolytic copper deposit obtained from the electroplating bath described above.

Further, the present invention provides a method for removing excess material from a semiconductor wafer by using a chemical mechanical planarization process which includes contacting the semiconductor wafer with a rotating polishing pad thereby removing the excess material from the semiconductor wafer; wherein the semiconductor wafer has been prior electroplated by the copper electroplating bath described above.

Still further, the present invention provides a method for removing excess material from a semiconductor wafer by using a chemical mechanical planarization process which includes contacting the semiconductor wafer with a rotating polishing pad thereby removing the excess material from the semiconductor wafer; wherein the semiconductor wafer has been prior electroplated using the copper electroplating bath described above.

### Detailed Description of the Invention

As used throughout the specification, the following abbreviations shall have the following meanings, unless the context clearly indicates otherwise: nm = nanometers; g/L = grams per liter; mA/cm² = milliamperes per square centimeter; M = molar; µm = micron = micrometer; ppm = parts per million, mL = milliliter; ° C = degrees Centigrade; g = grams; RPM = revolutions per minute; and Å = angstroms.

As used throughout the specification, "feature" refers to the geometries on a substrate, such geometries may be recessed or protruding. "Apertures" refer to recessed features, such as vias and trenches. The term "small features" refers to features that are one micron or smaller in size. "Very small features" refers to features that are one-half micron or smaller in size. Likewise, "small apertures" refer to apertures that are one micron or smaller in size and "very small apertures" refer to apertures that are one-half micron or smaller in size. As used throughout this specification, the term "plating" refers to copper electroplating, unless the context clearly indicates otherwise. "Deposition" and "plating" are used interchangeably throughout this specification. "Defects" refer to surface defects of a copper layer, such as protrusions and pits, as well as defects within a copper layer, such as voids.

The term "alkyl" includes linear, branched and cyclic alkyl. "Brightener" refers to an organic additive that increases the plating rate of a metal during electroplating. The terms "brightener" and "accelerator" are used interchangeable throughout this specification. "Suppressors" refer to organic additives that suppress the plating rate of a metal during electroplating. "Leveler" refers to an organic additive that is capable of providing a substantially planar metal layer. The terms "leveler" and "leveling agent" are used interchangeably through this specification. The term "halide" refers to fluoride, chloride, bromide and iodide.

All percentages and ratios are by weight unless otherwise indicated. All ranges are inclusive and combinable in any order except where it is clear that such numerical ranges are constrained to add up to 100%.

Electroplating solutions of the present invention generally include at least one source of copper ions such as a soluble copper salt, an electrolyte, and a suppressor compound capable of providing a copper filled, sub-micron sized aperture free of pits and voids. The electroplating solutions of the present invention may optionally contain one or more additives, such as halides, accelerators or brighteners, other suppressors, levelers, grain refiners, wetting agents, surfactants, defoamers, ductilizers, and the like.

A variety of copper salts may be employed in the present electroplating baths, including for example copper sulfate, copper sulfonate, copper acetate, copper gluconate, copper fluoroborate, cupric nitrate, copper alkanesulfonates and copper arylsulfonates. Suitable copper alkanesulfonates include copper methane sulfonate and copper ethanesulfonate. Suitable copper arylsulfonates include copper phenylsulfonates and copper tolylsulfonate. Copper sulfate pentahydrate is a particularly preferred copper salt. Mixtures of copper salts may also be used. The copper salt may be used in the present electroplating baths in a relatively wide concentration range. Typically, the copper salt is present in an amount sufficient to provide an amount of copper ion of 10 to 180 g/L in the plating bath. More typically, the amount of copper salt provides 15 to 65 g/L of copper ions in the plating bath. The copper plating bath may also contain amounts of other alloying elements, such as, but not limited to, tin, zinc, indium, antimony, and the like. Such alloying elements are added to the electroplating baths in the form of any suitable bath-solution salt. Thus, the copper electroplating baths useful in the present invention may deposit copper or copper alloy.

Plating baths useful in the present invention employ an electrolyte. Any suitable electrolyte may be used such as acidic or alkaline, and typically the electrolyte is acidic. When the electrolyte is acidic, the acid may be inorganic or organic. Suitable inorganic acids include, but are not limited to, sulfuric acid, phosphoric acid, nitric acid, hydrogen halide acids such as hydrochloric acid, sulfamic acid, fluoroboric acid and the like. Suitable organic acids include, but are not limited to, alkylsulfonic acids, aryl sulfonic acids such as phenylsulfonic acid and tolylsulfonic acid, carboxylic acids such as formic acid, acetic acid and propionic acid, halogenated acids such as trifluoromethylsulfonic acid and haloacetic acid, and the like. Particularly suitable organic acids include (C₁-C₁₀)alkylsulfonic acids, such as methansulfonic acid, ethanesulfonic acid and propanesulfonic acid. Other suitable electrolytes include pyrophosphate.

It will be appreciated by those skilled in the art that a combination of two or more acids may be used as the electrolyte. Particularly suitable combinations of acids include one or more inorganic acids with one or more organic acids or a mixture of two or more organic acids. Typically, the two or more acids may be present in any ratio. For example, when two acids are used, they may be present in any ratio from 99:1 to 1:99. Typically, the two acids are present in a ratio from 90:10 to 10:90, specifically from 80:20 to 20:80, more specifically from 75:25 to 25:75, and even more specifically from 60:40 to 40:60.

In one embodiment, the acids suitably used as the electrolyte include sulfuric acid, nitric acid, methanesulfonic acid, phenylsulfonic acid, mixtures of sulfuric acid and methanesulfonic acid, mixtures of methanesulfonic acid and phenylsulfonic acid, and mixtures of sulfuric acid, methanesulfonic acid and phenylsulfonic acid.

The total amount of added acid electrolyte used in the present electroplating baths may be from 0 to 100 g/L, and typically from 0 to 60 g/L, although higher amounts of acid may be used for certain applications, such as up to 225 g/L or even 300 g/L. It will be appreciated by those skilled in the art that by using copper sulfate, a copper alkanesulfonate or a copper arylsulfonate as the copper ion source, an acidic electrolyte can be obtained without any added acid.

In another embodiment, such as in the plating of wafers having very small apertures, electroplating baths having a low total amount of added acid may be used. By "low acid" is meant that the total amount of added acid in the electrolyte is less than 40 g/L, typically less than 30 g/L, and more typically less than 20 g/L.

The electrolyte may optionally contain one or more halides, and generally does contain at least one halide. Any halide may be used with chloride and bromide being the typical halides, and chloride being preferred. A wide range of halide ion concentrations (if a halide ion is employed) may be suitably utilized, e.g. from 0 (where no halide ion employed) to 100 ppm of halide ion in the plating solution. Other suitable ranges of halide ions include from 5 to 75 ppm, and more typically from 10 to 75 ppm. A particularly useful range of chloride ion is from 5 to 50 ppm.

The suppressor compounds useful in the present invention are those capable of providing a metal filled, such as copper filled, sub-micron sized aperture substantially free of defects, particularly pits and voids, and typically free of such defects. By "substantially free" of defects it is meant that the metal filled apertures contain less than 0.25 microprotrusions/cm² and preferably also show no evidence of pitting defects. Particularly suitable suppressor compounds are poly(alkylene oxide) random copolymers including as polymerized units two or more alkylene oxide monomers. Mixtures of such suppressor compounds may be used. Such random copolymers may be linear, star-shaped or the like. By "random copolymer" it is meant a copolymer having its repeat units randomly distributed along the copolymer chain.

A wide variety of alkylene oxide monomers may be used, such as, but not limited to, ethylene oxide, propylene oxide, butylene oxide, styrene oxide and the like. Typically, the poly(alkylene oxide) random copolymer is an ethylene oxide ("EO") / propylene oxide ("PO") random copolymer. Exemplary EO/PO random copolymers are those having the formula HO-(A)ₙ-(B)ₘ-H wherein each of A and B are selected from ethyleneoxy and propyleneoxy groups provided that A and B are different; and n and m are the number of A and B repeat units, respectively, in the copolymer. "Ethyleneoxy" refers to moieties having the formula -(CH₂-CH₂―O)―. "Propyleneoxy" refers to moieties having the formula -(CH(CH₃)-CH₂-O)- or -(O-CH(CH₃)-CH₂)-. Typically, n is in the range of 1 to 250 and specifically 10 to 170. Typically, m is in the range of 1 to 250 and specifically 10 to 90. Particularly useful EO/PO random copolymers are those having the formula HO(CH₂CH₂O)ₓ(CH₂CHCH₃O)_{y}H. In general, the ratio of x:y is from 10:90 to 95:5 and specifically from 50:50 to 75:25. It will be appreciated by those skilled in the art that the solubility of such EO/PO copolymers can be adjusted by changing the number of EO groups, PO groups or both groups.

Such poly(alkylene oxide) random copolymers may be linear or star-shaped copolymers. Such star copolymers are poly(alkylene oxide) random copolymers having 3 or more terminal hydroxyl groups. In general, each arm of the star shape terminates in a hydroxyl group. Typically, such star random copolymers have 3 or 4 terminal hydroxyl groups, although copolymers having a greater number of terminal hydroxyl groups may be employed.

In general, the present suppressor compounds have a molecular weight of 500 to 20,000. Typically, the molecular weight of the present suppressor compounds is from 700 to 15,000 and more typically from 1000 to 12,000. Although poly(alkylene oxide) random copolymers having a molecular weight that is lower or higher than these ranges may still be suitably employed.

The amount of such suppressors present in the electroplating baths is typically in the range of from 0.1 to 10,000 ppm. More typically, the suppressor compounds are present in an amount of from 0.5 to 1,000 ppm, and even more typically from 1 to 500 ppm. It will be appreciated by those skilled in the art that one or more other conventional suppressors may be used in combination with the suppressors of the present invention. Such combination may have advantages under certain circumstances where a balance of suppression characteristics is desired.

A wide variety of brighteners (or accelerators), including known brightener agents, may be employed in the copper electroplating compositions of the invention. Such brighteners may be used alone or as a mixture of two or more. Typical brighteners contain one or more sulfur atoms, and typically without any nitrogen atoms and a molecular weight of 1000 or less. Brightener compounds that have sulfide and/or sulfonic acid groups are generally preferred, particularly compounds that comprise a group of the formula R'-S-R-SO₃X, where R is an optionally substituted alkyl (which include cycloalkyl), optionally substituted heteroalkyl, optionally substituted aryl group, or optionally substituted heteroalicyclic; X is a counter ion such as sodium or potassium; and R' is hydrogen or a chemical bond (i.e. -S-R-SO₃X or substituent of a larger compound). Typically alkyl groups will have from one to 16 carbons, more typically one to 8 or 12 carbons. Heteroalkyl groups will have one or more hetero (N, O or S) atoms in the chain, and typically have from 1 to 16 carbons, more typically 1 to 8 or 12 carbons. Carbocyclic aryl groups are typical aryl groups, such as phenyl and naphthyl. Heteroaromatic groups also will be suitable aryl groups, and typically contain 1 to 3 N, O or S atoms and 1 to 3 separate or fused rings and include e.g. coumarinyl, quinolinyl, pyridyl, pyrazinyl, pyrimidyl, furyl, pyrrolyl, thienyl, thiazolyl, oxazolyl, oxidizolyl, triazole, imidazolyl, indolyl, benzofuranyl, benzothiazol, and the like. Heteroalicyclic groups typically will have 1 to 3 N, O or S atoms and from 1 to 3 separate or fused rings and include e.g. tetrahydrofuranyl, thienyl, tetrahydropyranyl, piperdinyl, morpholino, pyrrolindinyl, and the like. Substituents of substituted alkyl, heteroalkyl, aryl or heteroalicyclic groups include e.g. C₁₋₈ alkoxy; C₁₋₈ alkyl, halogen, particularly F, Cl and Br; cyano, nitro, and the like.

More specifically, useful brighteners include those of the following formulae:

XO₃ S―R―SH;

XO₃S―R―S―S―R―SO₃ X;

and

XO₃S―Ar―S―S―Ar―SO₃X;

wherein R in the above formulae is an optionally substituted alkyl group, and typically is an alkyl group having from 1 to 6 carbon atoms, more typically is an alkyl group having from 1 to 4 carbon atoms; Ar is an optionally substituted aryl group such as optionally substituted phenyl or naphthyl; and X is a suitable counter ion such as hydrogen, sodium or potassium.

Some specific suitable brighteners include e.g. N,N-dimethyl-dithiocarbamic acid-(3-sulfopropyl)ester; 3-mercapto-propylsulfonic acid-(3-sulfopropyl)ester; 3-mercapto-propylsulfonic acid (sodium salt); carbonic acid-dithio-o-ethylester-s-ester with 3-mercapto-1-propane sulfonic acid (potassium salt); bissulfopropyl disulfide; 3-(benzthiazolyl-s-thio)propyl sulfonic acid (sodium salt); pyridinium propyl sulfobetaine; 1-sodium-3-mercaptopropane-1-sulfonate; sulfoalkyl sulfide compounds disclosed in U.S. Pat. No. 3,778,357; the peroxide oxidation product of a dialkyl amino-thiox-methyl-thioalkanesulfonic acid; and combinations of the above. Additional suitable brighteners are also described in U.S. Pat. Nos. 3,770,598, 4,374,709, 4,376,685, 4,555,315, and 4,673,469. Particularly preferred brighteners for use in the plating compositions of the invention are N,N-dimethyl-dithiocarbamic acid-(3-sulfopropyl)ester and bis-sodium-sulfonopropyl-disulfide.

The amount of such brighteners present in the electroplating baths is typically from 0.1 to 1000 ppm. More typically, the brightener compounds are present in an amount of from 0.5 to 300 ppm, still more typically from 1 to 100 ppm, and even more typically from 2 to 50 ppm.

Levelers may optionally be added to the present electroplating baths. It is preferred that one or more leveler components is used in the present electroplating baths. Such levelers may be used in a wide range of amounts, such as from 0.01 to 50 ppm or greater. Examples of suitable leveling agents are described and set forth in U.S. Pat. Nos. 3,770,598, 4,374,709, 4,376,685, 4,555,315 and 4,673,459. In general, useful leveling agents include those that contain a substituted amino group such as compounds having R-N-R', where each R and R' is independently a substituted or unsubstituted alkyl group or a substituted or unsubstituted aryl group. Typically the alkyl groups have from 1 to 6 carbon atoms, more typically from 1 to 4 carbon atoms. Suitable aryl groups include substituted or unsubstituted phenyl or naphthyl. The substituents of the substituted alkyl and aryl groups may be, for example, alkyl, halo and alkoxy.

More specifically, suitable leveling agents include, but are not limited to, 1-(2-hydroxyethyl)-2-imidazolidinethione; 4-mercaptopyridine; 2-mercaptothiazoline; ethylene thiourea; thiourea; alkylated polyalkyleneimine; phenazonium compounds disclosed in U.S. Pat. No. 3,956,084; N-heteroaromatic rings containing polymers; quatemized, acrylic, polymeric amines; polyvinyl carbamates; pyrrolidone; and imidazole. An exemplary leveler is 1-(2-hydroxyethyl)-2-imidazolidinethione, although other suitable levelers may be employed.

Other suitable levelers are reaction products of an amine with an epihalohydrin, and preferably epichlorohydrin. Suitable amines include, but are not limited to, primary, secondary or tertiary amines, cyclic amines, aromatic amines and the like. Exemplary amines include, without limitation, dialkylamines, trialkylamines, arylalylamines, diarylamines, imidazole, triazole, tetrazole, benzimidazole, benzotriazole, piperidine, morpholine, piperazine, pyridine, oxazole, benzoxazole, pyrimidine, quinoline, isoquinoline, and the like. Imidazole being more preferred. Such amines may be substituted or unsubstituted. By "substituted", it is meant that one or more of the hydrogens are replaced by one or more substituent groups, such a alkyl, aryl, alkoxy, halo, alkenyl, and the like. Other suitable reaction products of amines with epichlorohydrin are those disclosed in U.S. Patent No. 4,038,161 (Eckles et al.). Such reaction products are generally commercially available, such as from Raschig, or may be prepared by methods known in the art.

When present, the leveling agents are typically used in an amount of 0.5 to 1000 ppm. More typically, the leveling agents are used in the range of 0.5 to 500 ppm, still more typically from 1 to 250 ppm, and even more typically from 1 to 50 ppm.

Exemplary electroplating baths of the present invention include 0 to 100 g/L, typically 0 to 6 g/L, of sulfuric acid; 10 to 65 g/L copper ions and typically 10 to 45 g/L of copper ions; 35 to 50 ppm of chloride ion; and 1 to 1,000 ppm of suppressor compound. More particularly, suitable baths further include 0 to 1000 ppm of brightener compound and 0.5 to 500 ppm of leveling agent.

The present invention is useful for depositing a layer of copper on a variety of substrates, particularly those substrates used in the manufacture of electronic devices. The present invention is particularly useful in the manufacture of printed wiring boards and integrated circuits. Accordingly, the present invention provides a method of depositing a copper layer on a substrate including the steps of: a) contacting a substrate with the copper plating bath described above; and b) applying a current density for a period time sufficient to deposit a layer of copper on the substrate.

The present copper electroplating compositions are suitably used in similar manner to prior copper electroplating baths. Plating baths of the invention may be employed at below room temperature, such as about 15° C, at room temperature or above room temperature, such as up to 65° C and greater. Typically, the plating baths are operated at a temperature in the range of 20 to 25° C. The plating composition is generally agitated during use such as by air sparger, work piece agitation, impingement or other suitable method. Plating is typically conducted at a current density ranging from 1 to 100 mA/cm², and more typically from 1 to 60 mA/cm², depending upon substrate characteristics. Plating time may range from about 2 minutes to 1 hour or more, depending on the difficulty of the work piece.

The present electroplating baths not only provide good fill of small apertures, e.g. 0.18 µm and smaller, but may, in an alternative embodiment, provide in-situ repair of a seed layer. The present copper plating baths are suitable for applying copper to an electrically conductive layer. Thus, an underlying conductive seed layer, typically a metal seed layer such as copper, is generally applied to the substrate prior to electrochemically depositing copper. Such seed layers may be applied by a variety of methods, such as physical vapor deposition ("PVD"; which includes sputtering, evaporation, or deposition from ionized metal plasma of hollow cathode magnetron sources) and chemical vapor deposition ("CVD", which includes deposition from metal or organometallic precursors comprising one of more metal atoms in combination with inorganic or organic ligands such as halides, pseudohalides, carbonyls, nitriles, alkyls, olefins, allyls, arenes, phosphines, amines, and the like).

Typically, seed layers are thin in comparison to other metal layers, such as from 50 to 1500 angstroms thick. Such seed layers are typically deposited by PVD techniques which deposits the copper seed layer in a line-of-sight fashion. Accordingly, discontinuities in the seed layer may exist when the substrate contains very small features. Such discontinuities in the seed layer may be problematic for subsequent electroplating to fill the features. It is desirable to repair or enhance such seed layers to remove any discontinuities. The present electroplating baths may be used to enhance such discontinuous seed layers. Accordingly, the present invention provides a method of repairing a seed layer including the steps of: a) contacting a substrate including a seed layer having discontinuities; b) contacting the substrate with the electroplating bath described above; and c) subjecting the electroplating bath to a current density sufficient to deposit sufficient copper to provide a uniform seed layer. By "uniform seed layer" it is meant a seed layer that has reduced discontinuities as compared to the number of discontinuities present prior to such treatment.

Exposure of marginally thin copper seed to highly acidic conventional electrolyte results in removal of the thin conductive copper oxide layer on the seed layer, exposing the underlying agglomerated copper seed layer (copper islands). When used to enhance seed layers containing oxidized copper, the present electroplating bath compositions are typically selected such that they are less acidic than conventional copper electroplating baths. Such less acidic baths have reduced copper oxide removal and copper seed layer corrosion than conventional plating baths. While not intending to be bound by theory, it is believed that the suppression provided by the present suppressors enhances the selective nucleation of the thin copper seed along the lower sidewalls of the apertures during the initial seconds of electroplating. The present compositions are believed to have higher copper nucleation rates within apertures than conventional electroplating baths.

Once the seed layer has been rendered continuous by the present method, the electroplating fill sequence proceeds by the normal bottom-up fill sequence. It will be appreciated by those skilled in the art that the use of a hot entry step in the plating waveform will further ensure the reduction or elimination of void formation on the thin copper seed layer. The choice of the particular waveform will depend upon the a number of factors known to those skilled in the art.

A wide variety of substrates may be plated with the compositions of the invention, as discussed above. The compositions of the invention are particularly useful to plate electronic devices, including without limitation, printed circuit board substrates such as printed circuit board inner layers and outer layers, flexible circuits and the like, integrated circuit ("IC") devices such as wafers used in IC manufacture having small apertures, semiconductor packaging such as lead frames, and the like.

The compositions of the invention are particularly suitable for plating substrates having apertures having a wide variety of dimensions. Typically, such substrates have one or more apertures having a size, such as a width, of ≤ 1 µm. Other suitable aperture sizes (widths) include, but are not limited to, 200 nm, 180 nm, 150 nm, 135 nm, 100 nm, 90 nm, 45 nm or even smaller. Such apertures may have a wide variety of aspect ratios, such as 1.5:1 or greater, and typically aspect ratios of 2:1, 3:1, 4:1, 5:1, 6:1, 7:1, 10:1 or greater, and even up to about 15:1 or greater. The present compositions can be used to effectively fill such apertures without defects (e.g. no voids or inclusions by ion beam examination).

The present invention provides a method of manufacturing an electronic device including the step of depositing a layer of copper on an electronic device including the steps of: a) contacting the electronic device with the electroplating bath described above; and b) applying current density for a period of time sufficient to deposit a layer of copper on the electronic device. Accordingly, the present invention also provides an article of manufacture including an electronic device containing a layer of copper deposited using the electroplating bath described above.

In a further embodiment, a copper diffusion barrier is selectively deposited on the surface of the copper deposited according to the present invention. Such selective deposition may be performed by a variety of means, such as immersion plating, or electroless plating. Any conducting material that inhibits or reduces copper migration into the adjoining dielectric layers may be used. Suitable diffusion barrier materials include, but are not limited to, nickel, chromium, cobalt, cobalt-tungsten-phosphide, silver, gold, palladium, platinum, ruthenium and the like. In immersion or displacement plating, metal deposition occurs when the dissolved metal ions in a plating bath are displaced by a more active (less noble) metal that is contacted with the plating bath. Immersion plating is particularly suitable it will not deposit metal on the surrounding dielectric, only on the exposed copper surfaces. In an alternate embodiment, a copper colloid composition, such as that disclosed in European Patent Application No. 0 707 093 A1, may be used to selectively deposit a platable colloid, followed by electrolessly or electrolytically plating metal on the platable colloid. A variety of electroless metal plating baths are suitable. Such copper diffusion barriers are particularly useful in the manufacture of integrated circuits.

An integrated circuit device (e.g. a semiconductor wafer) is generally plated with excess copper. During the process of manufacturing an integrated circuit, a semiconductor wafer is often polished to remove the excess unwanted materials on the surface of the wafer. Polishing generally takes the form of chemical-mechanical planarization ("CMP") wherein a chemically active slurry is used in conjunction with a polishing pad. Thus, once a semiconductor wafer is plated according to the present invention, the wafer is typically subjected to CMP. A CMP procedure can be conducted in accordance with the invention as follows.

The wafer is mounted in a wafer carrier which urges the wafer against the surface of a moving polishing pad. The polishing pad can be a conventional smooth polishing pad or a grooved polishing pad. Examples of a grooved polishing pad are described in United States Patent Nos. 5,177,908; 5,020,283; 5,297,364; 5,216,843; 5,329,734; 5,435,772; 5,394,655; 5,650,039; 5,489,233; 5,578,362; 5,900,164; 5,609,719; 5,628,862; 5,769,699; 5,690,540; 5,778,481; 5,645,469; 5,725,420; 5,842,910; 5,873,772; 5,921,855; 5,888,121; 5,984,769; and European Patent 806267. The polishing pad can be located on a conventional platen that can rotate the polishing pad. The polishing pad can be held on the platen by a holding means such as, but not limited to, an adhesive, such as, double-faced tape having adhesive on both sides.

A polishing solution or slurry is fed onto the polishing pad. The wafer carrier can be at different positions on the polishing pad. The wafer can be held in position by any suitable holding means such as, but is not limited to, a wafer holder, vacuum or liquid tensioning such as, but not limited to a fluid such as, but not limited to water. If the holding means is by vacuum then there is generally a hollow shaft which is connected to the wafer carrier. Additionally, the hollow shaft could be used to regulate gas pressure, such as, but not limited to air or an inert gas or use a vacuum to initially hold the wafer. The gas or vacuum would flow from the hollow shaft to the carrier. The gas can urge the wafer against the polishing pad for the desired contour. The vacuum can initially hold the wafer into position in the wafer carrier. Once the wafer is located on top of the polishing pad the vacuum can be disengaged and the gas pressure can be engaged to thrust the wafer against the polishing pad. The excess or unwanted copper is then removed. The platen and wafer carrier can be independently rotatable. Therefore, it is possible to rotate the wafer in the same direction as the polishing pad at the same or different speed or rotate the wafer in the opposite direction as the polishing pad.

Thus, the present invention provides a method for removing excess material from a semiconductor wafer by using a chemical mechanical planarization process which includes contacting the semiconductor wafer with a rotating polishing pad thereby removing the excess material from the semiconductor wafer; wherein the semiconductor wafer has been prior electroplated by the copper electroplating composition described above.

In another embodiment, the present plating bath may be used with advanced plating hardware (such as that available from NuTool, Inc., Milpitas, California) where the anode and cathode are in intimate contact, being separated by a porous membrane. Under such plating conditions, the surface of the resulting electrodeposited copper layer will be defect free and extremely level over narrow and wide features (0.1 to 100 µm wide). When using such advanced plating hardware, minimal copper deposition is required. In addition, such advanced plating hardware allows for minimizing the CMP planarization process.

While the present invention has been described with respect to copper electroplating baths, it will be appreciated by those skilled in the art that the present suppressor compounds may be used with a variety of plating baths, such as copper alloy, tin, tin alloy, nickel, nickel-alloy, and the like.

### Examples 1 to 18

Copper electroplating baths are prepared by combining 35 g/L copper ion added as copper sulfate, 45 g/L sulfuric acid and 45 ppm chloride ion, 10 mL/L of a conventional brightener, and approximately 4 to 10 mL/L of a poly(alkylene oxide) random copolymer indicated in Table 1. A leveling agent, a reaction product of diethylene glycol, imidazole and epichlorohydrin (0.5:1:1), is also added to each bath in an amount of 5 to 10 ppm.

**Table 1**

| **Example** | **Poly(alkylene oxide) Random** **Copolymer** |
|---|---|
| 1 | HO(CH₂CH₂O)₁₁(CH₂CHCH₃O)₂₆H |
| 2 | HO(CH₂CH₂O)₂₂(CH₂CHCH₃O)₅₂H |
| 3 | HO(CH₂CH₂O)₃₄(CH₂CHCH₃O)₇₈H |
| 4 | HO(CH₂CH₂O)₄₆(CH₂CHCH₃O)₁₀₃H |
| 5 | HO(CH₂CH₂O)₅₇(CH₂CHCH₃O)₁₂₉H |
| 6 | HO(CH₂CH₂O)₆₈(CH₂CHCH₃O)₁₅₅H |
| 7 | HO(CH₂CH₂O)₂₃(CH₂CHCH₃O)₁₇H |
| 8 | HO(CH₂CH₂O)₄₆(CH₂CHCH₃O)₃₅H |
| 9 | HO(CH₂CH₂O)₆₈(CH₂CHCH₃O)₅₂H |
| 10 | HO(CH₂CH₂O)₉₁(CH₂CHCH₃O)₁₀₃H |
| 11 | HO(CH₂CH₂O)₁₁₄(CH₂CHCH₃O)₈₆H |
| 12 | HO(CH₂CH₂O)₁₃₆(CH₂CHCH₃O)₁₀₃H |
| 13 | HO(CH₂CH₂O)₃₄(CH₂CHCH₃O)₉H |
| 14 | HO(CH₂CH₂O)₆₈(CH₂CHCH₃O)₁₇H |
| 15 | HO(CH₂CH₂O)₁₀₂(CH₂CHCH₃O)₂₆H |
| 16 | HO(CH₂CH₂O)₁₃₆(CH₂CHCH₃O)₃₅H |
| 17 | HO(CH₂CH₂O)₁₇₀(CH₂CHCH₃O)₄₃H |
| 18 | HO(CH₂CH₂O)₂₀₄(CH₂CHCH₃O)₅₂H |

Layers of copper are electroplated onto wafer substrates by contacting a spinning wafer (25 to 200 RPM) with one of the above electroplating baths at 25° C. A current density of up to 60 mA/cm² is applied and a copper layer is deposited on each wafer to a desired thickness, e.g., 1 µm. The layers of copper are analyzed by AFM to determine the surface roughness of the copper deposit. The copper deposit was also evaluated to determine its reflectivity ("Rf"). In addition, the copper deposit was evaluated by scanning electron microscopy ("SEM") and fast ion bombardment ("FIB"). The reflectivity value is relative to a polished silicon wafer having an Rf value of 100.

### Examples 19-36

Each of Examples 1-18 is repeated except that the copper electroplating bath contains 40 g/L copper as copper ions, 10 g/L sulfuric acid and 20 ppm chloride ion.

### Examples 37-54

Each of Examples 1-18 is repeated except that the copper electroplating bath contains 40 g/L copper as copper ions, 60 g/L sulfuric acid and 20 ppm chloride ion.

### Example 55 - Comparative

The copper plating bath of Example 1 is repeated except that the poly(alkylene oxide) copolymer is polyethylene glycol having a formula HO(CH₂CH₂O)₄₅H and a molecular weight of approximately 2,000. A layer of copper is deposited using this electroplating bath and the conditions described in Example 1. A visual inspection of the copper deposit shows numerous protrusions extending from the surface of the deposit. The surface of the deposit is analyzed and is found to have a lower Rf than the deposits obtained from Examples 1 to 54.

### Example 56

Two copper electroplating baths are prepared by combining 40 g/L copper ion added as copper sulfate, 10 g/L sulfuric acid and 50 ppm chloride ion, 10 mL/L of a conventional brightener, and < 10 ppm of a leveling agent which is a reaction product of diethylene glycol, imidazole and epichlorohydrin (0.5:1:1). To the first bath (Bath 1 - Comparative) is added an ethylene oxide / propylene oxide tri-block copolymer of the formula HO(CH₂CH₂O)₅(CH₂CHCH₃O)₃₂(CH₂CH₂O)₅H having a molecular weight of approximately 2,360 at a concentration of 4 mL/L as a suppressor. To the second bath (Bath 2 - Invention) is added an ethylene oxide / propylene oxide random copolymer having a molecular weight of approximately 2400 and an EO:PO ratio of approximately 75:25. A layer of copper is deposited on a semiconductor substrate using each electroplating bath and the conditions described in Example 1.

An inspection of the layer of copper deposited from Bath 1 shows numerous defects, such as pits, on the surface of the deposit. The surface of the layer of copper deposited from Bath 2 shows a very smooth (defect-free) surface. The surfaces of the deposits are analyzed by AFM and FIB to determine the root mean square roughness ("Rs"), arithmetic average roughness ("Ra") and height differential ("Z"). These results are reported in Table 2.

**Table 2**

| Bath | Suppressor | Ra (nm) | Rs (nm) | Z (nm) |
|---|---|---|---|---|
| 1- Comparative | EO / PO block copolymer | 4.5 | 5.7 | 50 |
| 2 - Invention | EO / PO random copolymer | 3.9 | 4.9 | 42 |

The lower the values of Ra and Rs are, the smoother the surface is. Lower values of Z indicate a more uniform surface height across the evaluated area. Thus, layers of copper having low Ra, Rs and Z-values are desired. As can be seen from the above data, the poly(alkylene oxide) random copolymer suppressor agents provide copper deposits having smoother surfaces as compared to conventional suppressors.

### Examples 57-74

Each of Examples 1-18 is repeated except that the layers of copper are electroplated onto printed wiring board substrates. The printed wiring board substrates typically have one or more through holes, via holes or both though holes and via holes that need to be electroplated with copper.

## Claims

1. A composition comprising one or more sources of copper ions, an electrolyte and one or more poly(alkylene oxide) random copolymers comprising as polymerized units two or more alkylene oxide monomers.

2. The composition of claim 1 wherein the poly(alkylene oxide) random copolymer is an ethylene oxide / propylene oxide random copolymer.

3. The composition of claim 2 wherein the ethylene oxide / propylene oxide random copolymer has the formula HO-(A)ₙ-(B)ₘ-H wherein each of A and B are selected from ethyleneoxy and propyleneoxy groups provided that A and B are different; and n and m are the number of A and B repeat units, respectively, in the copolymer.

4. The composition of any one of claims 1 to 3 wherein the poly(alkylene oxide) random copolymer is a linear copolymer or a star copolymer.

5. The composition of any one of claims 1 to 4 wherein the poly(alkylene oxide) random copolymer has a molecular weight of 500 to 20,000.

6. The composition of any one of claims 1 to 5 wherein the electrolyte is acidic.

7. A method of depositing a layer of copper on a substrate comprising the steps of contacting the substrate with the composition of any one of claims 1 to 6 and applying current density for a period of time sufficient to deposit a layer of copper on the substrate.

8. A method of manufacturing an electronic device comprising the step of depositing a layer of copper on an electronic device comprising the steps of contacting the electronic device substrate with the composition of any one of claims 1 to 6 and applying current density for a period of time sufficient to deposit a layer of copper on the electronic device.

9. The method of claim 7 or 8 wherein the substrate is a printed wiring board, lead frame or an integrated circuit.

10. The method of any one of claims 7 to 9 wherein the substrate has one or more apertures having a width of ≤ 1 µm.
